# FASCICULE DE BREVET EUROPEEN

(11) **EP 2 721 913 B1**
(45) Date de publication et mention de la délivrance du brevet: **23.01.2019**
(21) Numéro de dépôt: 12731568.7
(22) Date de dépôt: 14.06.2012
(51) Int. Cl.: H05K 9/00

(54) **DISPOSITIF POUR PROTEGER UN ESPACE A PROXIMITE D'UNE SOURCE MAGNETIQUE ET PROCEDE DE FABRICATION D'UN TEL DISPOSITIF**
VORRICHTUNG ZUM SCHUTZ EINES RAUMS NEBEN EINER MAGNETQUELLE UND VERFAHREN ZUR HERSTELLUNG EINER SOLCHEN VORRICHTUNG
DEVICE FOR PROTECTING A SPACE ADJACENT TO A MAGNETIC SOURCE, AND METHOD FOR MANUFACTURING SUCH A DEVICE

(30) Priorité: 20.06.2011 FR 1155411
(43) Date de publication de la demande: 23.04.2014
(73) Titulaire: Renault S.A.S., 92100 Boulogne-Billancourt (FR)
(72) Inventeur: STAEBLER, Patrick, F-78810 Feucherolles (FR)
(74) Mandataire: Rougemont, Bernard
(86) Numéro de dépôt international: PCT/FR2012/051328
(87) Numéro de publication internationale: WO 2012/175846

(56) Documents cités:
- EP-A1- 2 128 292
- EP-A2- 0 720 421
- DE-B3-102009 039 600
- JP-A- 2002 291 113
- US-A- 4 890 083

## Description

L'invention concerne un dispositif qui permet de protéger un espace à proximité d'une source magnétique.

Le document DE102009039600 divulgue un écran de protection magnétique dans un domaine de fréquences de 0 Hz à 1000 Hz, constitué d'au moins une couche plane de matériau ferromagnétique à structure non orientée combinée à au moins une couche d'aluminium.

Pour se protéger des ondes électromagnétiques produites par un moteur ou un câble de puissance de véhicule électrique, le document JP2002291113 propose un écran sous forme de feuille souple.

L'énergie magnétique rayonnée dans un espace à proximité d'une source magnétique peut perturber le fonctionnement de dispositifs électroniques (compatibilité électromagnétiques) et/ou présenter un danger pour un être humain qui occupe cet espace lorsque cette énergie résulte d'une puissance élevée même de courte durée ou d'une puissance plus faible mais à laquelle l'être humain est exposé plus longtemps.

Généralement un tel dispositif comprend un blindage ou écran multicouche, comme par exemple celui décrit dans le document EP1399929. Le blindage divulgué par ce document est enroulé autour d'un câble électrique. Il comprend au moins deux couches de matériau ferromagnétique.

Ce mode de blindage n'est pas approprié lorsque la source magnétique est de forme plus complexe qu'une simple forme tubulaire rectiligne. Ce peut être le cas lorsque la source magnétique ne se limite pas au câble lui-même mais englobe aussi des bornes de connexion ou divers équipement électroniques de puissance. Ce peut être le cas aussi pour un câble en soi lorsque celui-ci subit certaines courbures en mode statique dans le cheminement d'un équipement électrique à un autre ou en mode dynamique lorsque les câbles sont raccordés à des équipements mobiles. Ces courbures peuvent amener des ruptures dans les couches de matériau ferromagnétique qui ne permettent plus alors de canaliser correctement les lignes de champ magnétique et qui font alors perdre au blindage ses qualités d'écran magnétique.

En vue de remédier aux problèmes de l'état antérieur de la technique, l'invention a pour objet un dispositif pour protéger un espace à proximité d'une source magnétique, contre une énergie magnétique rayonnée par ladite source, comprenant une première feuille de matériau ferromagnétique déployée entre ledit espace et ladite source. Le dispositif est remarquable en ce qu'il comprend une première feuille de matériau électriquement conducteur de nature diamagnétique ou paramagnétique qui est déployée entre ladite première feuille de matériau ferromagnétique et ledit espace à protéger.

Particulièrement, le dispositif comprend une deuxième feuille de matériau électriquement conducteur de nature diamagnétique ou paramagnétique qui est déployée entre ladite première feuille de matériau ferromagnétique et ladite source magnétique.

Plus particulièrement, le dispositif comprend une deuxième feuille de matériau ferromagnétique qui est déployée entre ladite première feuille de matériau ferromagnétique et ladite première feuille de matériau électriquement conducteur.

Avantageusement, la ou les dites feuilles de matériau électriquement conducteur est ou sont de superficie supérieure à celle de la ou les feuilles de matériau ferromagnétique de manière à couvrir intégralement la ou les dites feuilles de matériau ferromagnétique.

De préférence, le matériau ferromagnétique a une perméabilité magnétique relative de valeur élevée supérieure à 100 000.

Particulièrement, le matériau ferromagnétique est un alliage amorphe à base de fer et à structure nanocristalline non orientée.

Plus particulièrement, ledit alliage comprend un élément chimique d'un groupe comprenant le cobalt et le nickel.

Plus particulièrement encore, au moins une feuille de matériau ferromagnétique est recouverte d'au moins une couche de matériau électriquement isolant.

De préférence aussi, le matériau électriquement conducteur de nature diamagnétique ou paramagnétique comprend de l'aluminium.

L'invention a également pour objet un procédé de fabrication d'un dispositif pour protéger un espace à proximité d'une source magnétique contre une énergie magnétique rayonnée par ladite source. Le procédé est remarquable en ce qu'il comprend des étapes consistant à :
- façonner une première feuille de matériau électriquement conducteur de nature diamagnétique ou paramagnétique de façon à pouvoir la déployer avec une première face en regard dudit espace à protéger ;
- déployer une ou plusieurs feuilles de matériau ferromagnétique sur une deuxième face de ladite première feuille de matériau électriquement conducteur de nature diamagnétique ou paramagnétique, opposée à ladite première face de ladite première feuille de matériau électriquement conducteur.

Particulièrement, le procédé de fabrication comprend en outre des étapes consistant à :
- façonner une deuxième feuille de matériau électriquement conducteur de nature diamagnétique ou paramagnétique de façon à pouvoir la déployer avec une première face en regard de la source magnétique ;
- positionner ladite deuxième feuille de matériau électriquement conducteur de sorte que la ou les feuilles de matériau ferromagnétique sont déployées sur une deuxième face de ladite deuxième feuille de matériau électriquement conducteur, opposée à ladite première face de ladite deuxième feuille de matériau électriquement conducteur.

L'invention couvre spécialement un objet mobile comprenant au moins un organe électrique qui est une source de rayonnement magnétique. L'objet mobile est marquant en ce qu'il comprend un dispositif selon l'invention de façon à assurer une protection de masse faible contre une énergie magnétique rayonnée par ladite source.

Notamment, l'objet mobile couvert par l'invention est un véhicule automobile comprenant un habitacle qui comporte un espace à proximité du dit organe. De manière avantageuse, le dispositif conforme à l'invention est disposé dans le véhicule automobile entre l'organe et l'habitacle.

L'invention est particulièrement intéressante pour toute application où la légèreté, en d'autres termes le gain de masse est important, par exemple tous véhicules (aéronefs, trains, ...), systèmes portatifs ou autres objets mobiles.

L'invention sera mieux comprise à l'aide d'exemples de réalisation d'un dispositif conforme à l'invention en référence aux dessins annexés, dans lesquels :
- la figure 1 est une vue schématique d'un dispositif conforme à l'invention ;
- la figure 2 est une vue schématique d'un autre dispositif conforme à l'invention ;
- la figure 3 est une vue éclatée de composants façonnés et combinés conformément au procédé selon l'invention ;
- la figure 4 est une vue schématique d'un véhicule automobile conforme à l'invention.

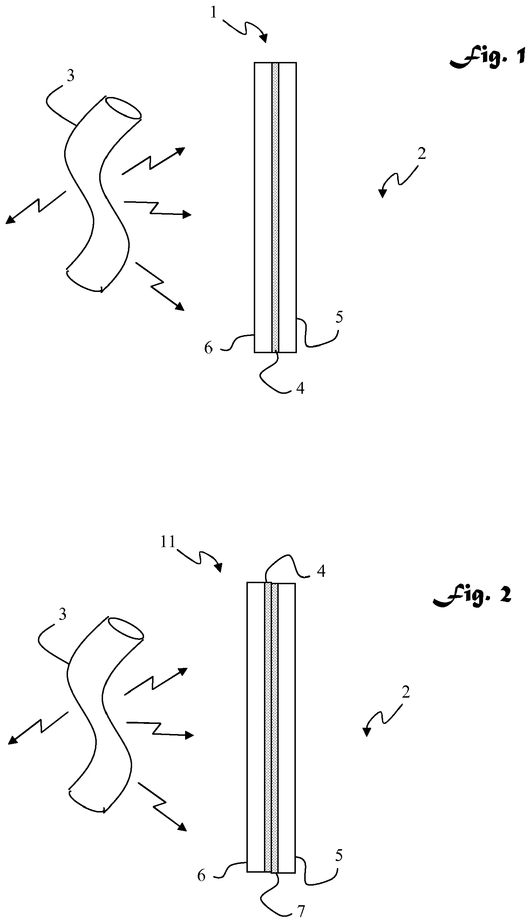

La figure 1 montre un dispositif 1 pour protéger un espace 2 à proximité d'une source magnétique 3, contre une énergie magnétique rayonnée par la source 3.

Un tel dispositif est nécessaire dans de nombreux domaines pour protéger un être humain contre l'énergie magnétique rayonnée par des appareils qui lui sont utiles par ailleurs.

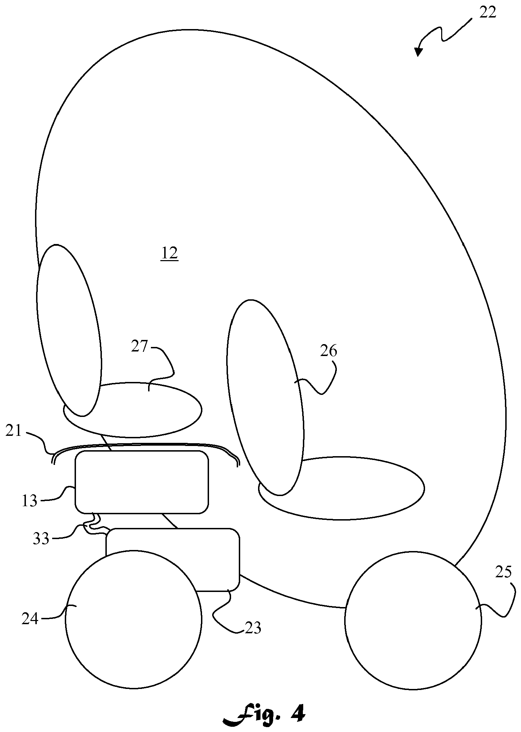

Notamment, le véhicule 22 représenté en figure 4 comprend des roues 24, 25 et une machine 23 pour entraîner tout ou partie de ces roues. La machine 23 est contrôlée par un bloc d'alimentation électrique 13.

Lorsque la machine 23 est un moteur thermique, le bloc d'alimentation électrique 13, d'une première nature, génère par exemple des séquences d'allumage dans le cas d'une combustion essence et/ou des séquences de commande d'injecteurs dans le cas d'une combustion essence ou diesel.

Lorsque la machine 23 est une machine électrique, le bloc d'alimentation électrique 13, d'une deuxième nature, génère notamment le courant électrique qui fait fonctionner la machine 23 en moteur ou en génératrice selon le sens positif ou négatif du courant. Le bloc d'alimentation électrique 13 regroupe alors une batterie et une électronique de puissance.

Le bloc d'alimentation électrique 13 et notamment le ou les câbles 33 qui relient le bloc d'alimentation électrique à la machine 23, sont des organes qui constituent une source de champ magnétique, statique ou, notamment lorsque le courant varie, rayonné.

D'autres organes dans un véhicule automobile ou dans d'autres environnements, peuvent aussi constituer une source 3 de champ magnétique statique ou rayonné.

Le véhicule 22 comprend un habitacle équipé de sièges 26, 27 pour accueillir respectivement un conducteur et au moins un passager. De façon à réduire le plus possible l'encombrement du véhicule ici représenté, le siège 27 est placé au dessus des organes 13, 23, 33. La partie de l'habitacle occupée par le siège 27, comporte ainsi un espace 12 à proximité de la source magnétique. L'espace 12 nécessite un dispositif 21 qui fait écran au rayonnement magnétique de façon à ne pas exposer le passager à des champs magnétiques qui peuvent être préjudiciable à sa santé.

D'autres espaces peuvent nécessiter une protection pour éviter d'exposer des personnes à des champs magnétiques, par exemple à titre purement illustratif et non limitatif à proximité de postes de transformation électrique ou de lignes de distribution électrique en courants forts dans une usine.

De manière générale, le dispositif 1 de la figure 1 comprend une feuille 4 **de matériau** ferromagnétique déployée entre l'espace 2 et la source magnétique 3.

On a cherché à obtenir les meilleures performances possibles de réduction de champ magnétique à proximité de la source au meilleur coût et en gardant à l'esprit la nécessité de limiter le poids du dispositif 1. En effet la légèreté est un critère d'importance fondamentale dans de nombreuses réalisations techniques, notamment dans les véhicules automobiles.

On rappelle que le théorème d'Ampère énonce de manière connue en régime permanent ou quasi permanent, un lien de proportionnalité entre la circulation du champ magnétique B sur une courbe fermée et le courant électrique traversant la surface délimitée par cette courbe fermée.

On sait que dans le vide, le coefficient de proportionnalité est égal à la perméabilité magnétique du vide µ₀ qui vaut 4πx10⁻⁷ Tm/A. La perméabilité magnétique µ d'un milieu différent du vide est obtenue en multipliant la perméabilité du vide par un coefficient de proportionnalité µᵣ nommé perméabilité relative qui caractérise le milieu.

En régime dynamique, c'est le théorème d'Ampère Maxwell qui énonce la relation entre le champ magnétique et le courant électrique en faisant intervenir les variations temporelles de champ électrique.

On a utilisé les connaissances ci-dessus énoncées pour faire varier un courant électrique dans la source 3 de façon à obtenir un champ magnétique généré par la source magnétique, à des fréquences qui décrivent un spectre variant de quelques Hz à plusieurs MHz.

En relevant l'énergie magnétique rayonnée cumulée sur une plage de fréquences inférieures à un seuil donné, on a constaté une augmentation brutale d'énergie rayonnée cumulée pour une valeur de seuil comprise entre 10 et 100 Hz puis une augmentation plus progressive pour des valeurs de seuil comprises entre 100 Hz et 1000 Hz. L'énergie magnétique cumulée augmente ensuite faiblement en tendant vers une valeur asymptotique pour des valeurs de seuil comprises entre 1000 Hz et 10 MHz.

Fort de cette constatation, on a recherché à configurer le dispositif 1 de manière à atténuer le plus fortement possible les champs magnétiques compris dans une plage de fréquences variant de 10 Hz à 1kHz, voire jusqu'à 10 kHz.

Dans ces bandes de fréquences, les matériaux qui conviennent le mieux pour faire écran aux champs magnétiques, sont a priori les matériaux ferromagnétiques.

Si on sait que les matériaux électriquement conducteurs paramagnétiques tels que l'aluminium permettent d'atténuer de manière appréciable les champs magnétiques à fréquences élevées, ils conviennent mal pour faire écran aux champs magnétiques à basse fréquence. Alors qu'une plaque d'aluminium de dimensions limitées et de 1 mm d'épaisseur a permis d'obtenir une atténuation de -58 dB dans une bande de fréquences comprises entre 100 kHz et 2 MHz, cette même plaque n'a permis qu'une atténuation limitée à seulement -2 dB pour des fréquences inférieures à 100 Hz et à seulement -7 dB pour des fréquences proches de 400 Hz.

Pour le matériau ferromagnétique, on a recherché un matériau ferromagnétique possédant une perméabilité magnétique relative µᵣ de valeur élevée, en d'autres termes supérieure à 100 000 de façon à obtenir une bonne efficacité à basses fréquences.

C'est par exemple le cas du mu métal composé de sensiblement 77 à 80% de Nickel, de sensiblement 15% de fer complété par du cuivre et ou du molybdène. Ce matériau a la particularité d'avoir une perméabilité relative de l'ordre de 150 000 qui favorise la déviation des lignes de champ magnétique à basse fréquence et une température de Curie de l'ordre de 420 °C qui convient très bien à des environnements chauds comme on peut en rencontrer à proximité d'un moteur.

En faisant évoluer la fréquence de 10 Hz à 10 MHz, on a d'une part mesuré le champ magnétique entre la source 3 et le dispositif 1 et on a d'autre part mesuré le champ magnétique dans l'espace 2 au-delà du dispositif 1 à endroits fixes de part et d'autre du dispositif 1 de façon à pouvoir comparer les mesures. Pour chaque fréquence, le rapport entre les deux mesures donne une atténuation procurée par le dispositif écran.

Une feuille de mu métal permet d'obtenir une atténuation sensiblement constante variant alternativement faiblement autour de -7,5 dB dans la plage de fréquences de 10 Hz à 1000 Hz, diminuant jusqu'à sensiblement -17 dB dans la plage de 1 à 4 kHz puis restant sensiblement constante autour de cette dernière valeur au-delà de 4 kHz. Ces valeurs dépendent également de la taille de la feuille.

On a aussi étudié les possibilités d'utiliser un alliage amorphe à base de fer et à structure nanocristalline non orientée comme matériau ferromagnétique en vue d'augmenter les performances d'atténuation. Pour distinguer cette classe de celle du mu métal, nous désignerons dans la suite de la description les matériaux qui lui appartiennent par l'acronyme ANFM (Amorphe Nanocristallin Ferro Magnétique).

Dans cette classe de matériaux, le NANOPERM™ est un alliage à base de fer comprenant du silicium et en quantités plus faible du cuivre, du niobium et du bore. Il permet d'atteindre une perméabilité magnétique de 200 000 selon son fournisseur. Le descriptif fournisseur indique un coefficient de magnétostriction inférieur à 0,5 ppm.

Dans cette classe de matériaux, le FINEMET™ est un alliage à base de fer qui comprend aussi un élément chimique d'un groupe comprenant le silicium. Le descriptif fournisseur indique une perméabilité magnétique relative µᵣ de l'ordre de 70 000 et un coefficient de magnétostriction très faible de l'ordre de 10⁻⁷. Ce coefficient de magnétostriction faible est bénéfique dans la lutte contre le bruit généré par les champs magnétiques oscillant dans les bandes de fréquence audibles.

Une feuille de FINEMET™ est une feuille de matériau ferromagnétique recouverte sur chacune de ses faces par une couche de matériau électriquement isolant.

Chaque couche de matériau électriquement isolant comporte un film de PET (Polyéthylène Téréphtalate) sur une épaisseur de 25 µm relié à la feuille de matériau ferromagnétique par une couche de matériau adhésif une épaisseur de 25 µm. L'épaisseur du matériau ferromagnétique quant à elle, étant égale à 18 µm, on obtient ainsi une feuille de matériau ANFM de 0,12 mm d'épaisseur.

En répétant la même expérience qu'avec le mu métal, une feuille de matériau ANFM de 0,12 mm d'épaisseur, a permis d'obtenir une atténuation sensiblement constante variant alternativement faiblement autour de -2 dB dans la plage de fréquences de 10 Hz à 1000 Hz, évoluant jusqu'à sensiblement -14 dB dans la plage de 1 à 5 kHz puis restant sensiblement constante autour de cette dernière valeur au-delà de 5 kHz.

Une superposition de deux feuilles de matériau ANFM de 0,12 mm d'épaisseur, a permis d'obtenir une atténuation sensiblement constante variant alternativement faiblement autour de -4 dB dans la plage de fréquences de 10 Hz à 1000 Hz, évoluant jusqu'à sensiblement -15 dB dans la plage de 1 à 3 kHz puis restant sensiblement constante autour de cette dernière valeur au-delà de 3 kHz. On constate que le doublement des feuilles procure une amélioration de performance purement proportionnelle à basses fréquences et une amélioration quasiment nulle à hautes fréquences.

Une superposition de trois feuilles de matériau ANFM de 0,12 mm d'épaisseur, a permis d'obtenir une atténuation sensiblement constante variant alternativement faiblement autour de -6 dB dans la plage de fréquences de 10 Hz à 1000 Hz, atteignant sensiblement -10 dB dans la plage de 1 à 2 kHz puis restant sensiblement constante autour de cette dernière valeur au-delà de 2 kHz. On constate que le triplement des feuilles procure une faible amélioration de performance à basses fréquences et une dégradation à hautes fréquences.

En vue de remédier aux dégradations de performances à hautes fréquences, on a déployé une feuille d'aluminium entre la source et la ou les feuilles de matériau ferromagnétique. La feuille de matériau électriquement conducteur, éliminant ou pour le moins réduisant fortement les composantes à hautes fréquences du champ magnétique, soulage ainsi la fonction d'écran à remplir par le matériau ferromagnétique en ne lui transmettant essentiellement que les composantes à basses fréquences du champ magnétique.

En déployant une feuille d'aluminium de 1 mm d'épaisseur entre la source 3 et une feuille de matériau ANFM de 0,12 mm d'épaisseur, on a obtenu une atténuation évoluant de -3 dB à -17 dB dans la plage de fréquences de 10 Hz à 1000 Hz, puis restant sensiblement constante autour de -25 dB au-delà de 2 kHz. On constate que le déploiement d'une feuille de matériau électriquement conducteur de nature paramagnétique, procure une amélioration de performance à hautes fréquences et déjà notable à relativement basses fréquences dès 700 Hz où on obtient une atténuation de -15 dB.

En déployant la feuille d'aluminium de 1 mm d'épaisseur entre la source 3 et deux feuilles de matériau ANFM de 0,12 mm d'épaisseur, on a obtenu une atténuation évoluant de -4 dB à -18 dB dans la plage de fréquences de 10 Hz à 1000 Hz, puis restant sensiblement constante autour de -30 dB au-delà de 3 kHz. On constate que le déploiement de la feuille de matériau électriquement conducteur de nature paramagnétique entre la source 3 et deux feuilles de matériau ferromagnétique, procure une faible amélioration de performance par rapport au déploiement de la feuille d'aluminium entre la source 3 et une seule feuille de matériau ANFM.

De façon surprenante, en déployant la feuille d'aluminium de 1 mm d'épaisseur sur la face de la feuille de matériau ANFM de 0,12 mm d'épaisseur qui est opposée à la face en regard de la source 3, on a obtenu une atténuation évoluant de -3 dB à -22 dB dans la plage de fréquences de 100 Hz à 1000 Hz, puis restant sensiblement constante autour de -25 dB au-delà de 2 kHz. On constate que le déploiement d'une feuille de matériau électriquement conducteur de nature paramagnétique derrière la feuille de matériau ferromagnétique par rapport à la source 3, procure une amélioration de performance à basses fréquences qui est nettement supérieure à celle obtenue avec les deux expériences qui précèdent ci-dessus. Cette configuration permet d'obtenir avec une seule feuille de matériau ANFM, des performances supérieures à celles obtenues avec deux feuilles de matériau ANFM dans la configuration opposée. Tous paramètres étant égaux par ailleurs, l'atténuation augmente lorsque l'épaisseur de la ou les feuille(s) d'aluminium croît ou croissent.

Ce résultat n'est pas évident a priori car dans cette dernière configuration, la soumission de la feuille de matériau ferromagnétique à la totalité du champ magnétique avant propagation vers la feuille de matériau paramagnétique, devrait tendre à favoriser les phénomènes de saturation dans le matériau ferromagnétique.

Ce résultat est avantageux car il augmente les performances tout en divisant par deux les coûts impactés par ceux des feuilles de matériau ANFM, or ces derniers sont relativement élevés.

En déployant la feuille d'aluminium de 1 mm d'épaisseur sur deux feuilles de matériau ANFM de 0,12 mm d'épaisseur à l'opposé de la source 3, on a obtenu une atténuation évoluant de -8 dB à -22 dB dans la plage de fréquences de 10 Hz à 1000 Hz, puis restant sensiblement constante autour de -30 dB au-delà de 3 kHz. On constate que le déploiement de la feuille de matériau électriquement conducteur de nature paramagnétique sur deux feuilles de matériau ferromagnétique à l'opposé de la source 3, ne procure quasiment pas d'amélioration de performance par rapport au déploiement de la feuille d'aluminium sur une seule feuille de matériau ANFM.

On obtient donc un premier optimum en termes d'efficacité et de coûts en déployant une feuille de matériau électriquement conducteur non ferromagnétique sur la face d'une seule feuille de matériau ferromagnétique qui est opposée à la face en regard de la source magnétique.

Dans le dispositif de la figure 1, on se félicite du déploiement d'une feuille 5 de matériau électriquement conducteur de nature diamagnétique ou paramagnétique entre la feuille 4 et l'espace à protéger 2.

Néanmoins, on a essayé de trouver d'autres voies pour améliorer encore les performances.

De façon surprenante encore, en déployant une deuxième feuille d'aluminium de 1 mm d'épaisseur sur l'autre face d'une seule feuille de matériau ANFM de 0,12 mm d'épaisseur, on a obtenu une atténuation évoluant de -5 dB à -35 dB dans la plage de fréquences de 100 Hz à 600 Hz, évoluant ensuite plus progressivement pour atteindre -37 dB à 1000 Hz puis restant sensiblement constante autour de -37 dB au-delà de 1 kHz. On constate que le déploiement d'une feuille de matériau électriquement conducteur de nature paramagnétique de part et d'autre de la feuille de matériau ferromagnétique par rapport à la source 3, procure une amélioration de performance à basses fréquences qui est nettement supérieure à la somme de celles obtenues avec les expériences qui précèdent et qui utilisent une feuille de matériau électriquement conducteur non ferromagnétique combinée avec une feuille de matériau ferromagnétique. Cette configuration permet d'obtenir avec une seule feuille de matériau ANFM, des performances supérieures à celles obtenues avec les expériences précédentes. Ici encore, on note que tous paramètres étant égaux par ailleurs, l'atténuation augmente lorsque l'épaisseur de la feuille d'aluminium croît.

Ce résultat n'est pas évident a priori car dans cette dernière configuration, l'effet technique d'écran aux champs magnétiques, procuré par la combinaison des feuilles tel qu'il est observé, est considérablement supérieur à la somme des effets procurés par chacune des feuilles et même à la somme des combinaisons de feuilles deux à deux.

Bien entendu, l'ajout d'une feuille de métal non ferromagnétique supplémentaire peut avoir des répercussions de coût et de poids, ce dernier constituant un facteur de choix important, notamment dans une application mobile. Selon l'intensité admissible d'énergie magnétique rayonnée, on pourra se contenter d'une seule feuille de matériau électriquement conducteur non ferromagnétique superposée sur la face d'une feuille de matériau ferromagnétique du côté de l'espace à protéger.

Cependant, lorsque l'intensité des champs magnétiques justifie une légère augmentation de coût et de poids, sachant que l'aluminium est un métal relativement léger en comparaison de certains autres et de coût nettement inférieur à celui des feuilles de matériaux combinant forte perméabilité magnétique, niveau élevé de seuil de saturation magnétique et faible magnétostriction comme c'est le cas du FINEMET™, l'invention enseigne une préférence marquée pour l'utilisation de deux feuilles de métal non ferromagnétique, plus précisément de métal paramagnétique.

Ainsi, le dispositif 1 de la figure 1 comprend une deuxième feuille 6 de matériau électriquement conducteur de nature diamagnétique ou paramagnétique qui est déployée entre la feuille 4 de matériau ferromagnétique et la source magnétique 3.

Il ressort des essais ci-dessus exposés qu'une multiplication de feuilles de matériau ferromagnétique, apporte peu de gain en performances.

Néanmoins, on a pratiqué des essais en intercalant plusieurs feuilles de matériau ferromagnétique entre deux feuilles de métal non ferromagnétique.

Une superposition de deux feuilles de FINEMET™ de 0,12 mm d'épaisseur entre deux feuilles d'aluminium de 1 mm d'épaisseur, a permis d'obtenir une atténuation évoluant avec une forte pente de -7 dB pour une fréquence de 50 Hz jusqu'à -35 dB pour une fréquence de 350 Hz, évoluant encore mais avec une faible pente jusqu'à sensiblement -37 dB à 1 kHz puis restant sensiblement constante autour de -36 dB au-delà de 5 kHz. Contrairement aux essais précédents, on constate que le doublement des feuilles procure une amélioration de performance notable à basses fréquences et une légère tendance à s'inverser à hautes fréquences.

Une superposition de trois feuilles de FINEMET™ de 0,12 mm d'épaisseur entre deux feuilles d'aluminium de 1 mm d'épaisseur, a permis d'obtenir une atténuation évoluant encore avec une forte pente quasi identique de -10 dB pour une fréquence de 50 Hz jusqu'à -35 dB pour une fréquence de 400 Hz, puis restant sensiblement constante autour de -33 dB au-delà de 1 kHz. On constate que le doublement des feuilles procure une amélioration de performance notable à basses fréquences et une légère tendance à s'inverser à hautes fréquences.

Une solution optimale apparaît être celle de la figure 2 sur laquelle le dispositif 11 comprend une deuxième feuille 7 de matériau ferromagnétique qui est déployée entre la première feuille 4 de matériau ferromagnétique et la première feuille 5 de matériau électriquement conducteur.

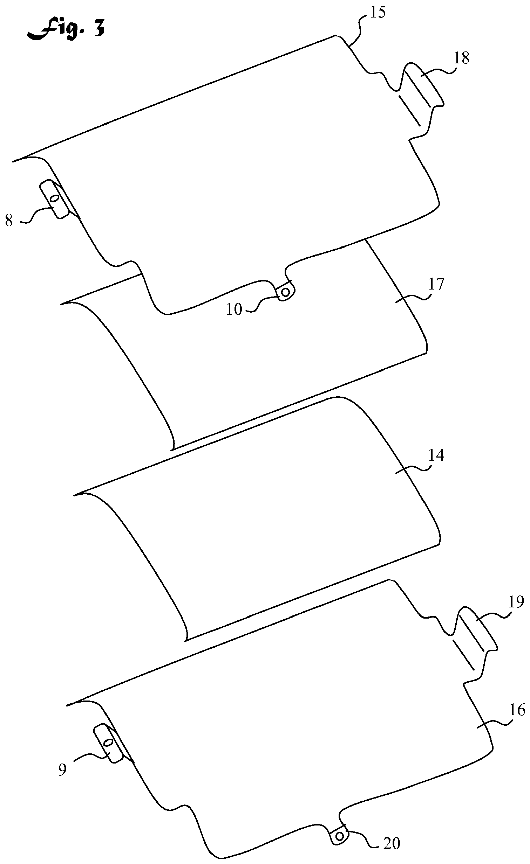

La figure 3 permet d'expliquer un procédé de fabrication du dispositif pour protéger l'espace à proximité de la source magnétique contre l'énergie magnétique rayonnée par la source.

Une première étape consiste à façonner une première feuille 15 de matériau électriquement conducteur de nature diamagnétique ou paramagnétique. Le façonnage comprend des actions de déformation sous presse d'une tôle, par exemple de 1 mm d'épaisseur comprenant de l'aluminium ou des actions de moulage d'une plaque lorsque le matériau se prête difficilement à l'emboutissage. De façon à pouvoir déployer la feuille 15 avec une première face en regard de l'espace à protéger, on découpe, on plie et/ou on usine des oreillettes 8, 10 dans lesquelles on perce des trous qui permettront de fixer la feuille en bordure de l'espace à protéger. On peut aussi façonner une languette 18 non percée en vue d'un mode de fixation par collage ou pour toute autre fonction.

Une deuxième étape consiste à façonner une deuxième feuille 16 de matériau électriquement conducteur de nature diamagnétique ou paramagnétique de manière semblable à celle de la première étape. De façon à pouvoir déployer la feuille 16 avec une première face en regard de la source magnétique, on découpe, on plie et/ou on usine des oreillettes 9, 20 superposables aux oreillettes 8, 10 et dans lesquelles on perce des trous qui permettront de fixer la feuille 16 avec la feuille 15. On peut aussi façonner une languette 19 non percée en vue de coopérer avec la languette 18.

Une troisième étape consiste à déployer une ou plusieurs, de préférence deux, feuilles 14, 17 de matériau ferromagnétique sur une deuxième face de la première feuille 15 de matériau électriquement conducteur, opposée à la première face de la première feuille 15. La superficie de chacune des feuilles 14, 17 est de préférence inférieure à celle de chacune des feuilles 15, 16 de matériau électriquement conducteur de manière à pouvoir être couvertes intégralement par les feuilles 15, 16. Notamment, le feuilles 14, 17 ne se prêtant qu'à une déformation par cintrage dans une seule direction, elles ne sont pas mises en contact avec les oreillettes 8, 9, 10, 20 pour éviter de les rompre lors d'un pliage qui serait destructeur.

Une quatrième étape consiste à positionner la deuxième feuille 16 de matériau électriquement conducteur de sorte que la ou les feuilles 14, 17 de matériau ferromagnétique sont déployées sur une deuxième face de la deuxième feuille 16 de matériau électriquement conducteur, opposée à la première face de la deuxième feuille 16 de matériau électriquement conducteur.

Le procédé que l'on vient de décrire est celui d'un mode de réalisation. L'homme du métier envisagera de lui-même différentes manières de le modifier sans sortir du cadre de la présente invention. Notamment, il pourra supprimer les deuxièmes et quatrièmes étapes lorsqu'il préférera se contenter d'une seule feuille d'aluminium. Il pourra inverser l'ordre des étapes, les deux premières pouvant être exécutées indifféremment l'une avant l'autre ou en parallèle. De même la quatrième étape peut être exécutée avant la troisième en positionnant les feuilles 14 et 17 sur la feuille 16 puis en venant ensuite positionner la feuille 15 sur l'empilement ainsi obtenu.

De manière synthétique, dans la configuration exposée, principalement une feuille supplémentaire de FINEMET réduit la fréquence de coupure basse tandis que l'épaisseur d'aluminium augmente l'atténuation.

## Revendications

1. Dispositif (1, 11, 21) pour protéger un espace (2, 12) à proximité d'une source magnétique (3, 33) de forme plus complexe qu'une simple forme tubulaire rectiligne, contre une énergie magnétique rayonnée par ladite source, **caractérisé en ce qu'**il comprend :
- une première feuille (5, 15) de matériau électriquement conducteur de nature diamagnétique ou paramagnétique qui est façonnée par actions de déformation ou de moulage de manière à pouvoir être déployée entre ladite source (3, 33) et ledit espace à protéger (2, 12),
- une première feuille (4, 14) de matériau ferromagnétique façonnée par cintrage de manière à pouvoir être déployée entre ladite source (3, 33) et ladite première feuille (5, 15) de matériau électriquement conducteur, le matériau ferromagnétique étant un alliage amorphe à base de fer et à structure nanocristalline non orientée,
et **en ce que** la première feuille (5, 15) de matériau électriquement conducteur de nature diamagnétique ou paramagnétique et la première feuille (4, 14) de matériau ferromagnétique sont superposées.

2. Dispositif (1, 11, 21) selon la revendication 1, **caractérisé en ce qu'**il comprend :
- une deuxième feuille (6, 16) de matériau électriquement conducteur de nature diamagnétique ou paramagnétique qui est façonnée de manière à être déployée entre ladite première feuille (4, 14) de matériau ferromagnétique et ladite source magnétique (3, 33) .

3. Dispositif (11, 21) selon l'une des revendications 1 ou 2, **caractérisé en ce qu'**il comprend :
- une deuxième feuille (7, 17) de matériau ferromagnétique qui est déployée entre ladite première feuille (4, 14) de matériau ferromagnétique et ladite première feuille (5, 15) de matériau électriquement conducteur.

4. Dispositif (21) selon l'une des revendications précédentes, **caractérisé en ce que** la ou lesdites feuilles (15, 16) de matériau électriquement conducteur est ou sont de superficie supérieure à celle de la ou les feuilles (14, 17) de matériau ferromagnétique de manière à couvrir intégralement la ou lesdites feuilles de matériau ferromagnétique.

5. Dispositif (1, 11, 21) selon l'une des revendications précédentes, **caractérisé en ce que** le matériau ferromagnétique a une perméabilité magnétique relative (µᵣ) de valeur élevée supérieure à 100 000.

6. Dispositif (1, 11, 21) selon l'une des revendications précédentes, **caractérisé en ce que** ledit alliage comprend un élément chimique d'un groupe comprenant le silicium.

7. Dispositif (1, 11, 21) selon l'une des revendications précédentes, **caractérisé en ce qu'**au moins une feuille (4, 14, 7, 17) de matériau ferromagnétique est recouverte d'au moins une couche de matériau électriquement isolant.

8. Dispositif selon l'une des revendications précédentes, **caractérisé en ce que** le matériau électriquement conducteur de nature diamagnétique ou paramagnétique comprend de l'aluminium.

9. Procédé de fabrication d'un dispositif pour protéger un espace à proximité d'une source magnétique contre une énergie magnétique rayonnée par ladite source, **caractérisé en ce qu'**il comprend des étapes consistant à :
- façonner par actions de déformation ou de moulage une première feuille (15) de matériau électriquement conducteur de nature diamagnétique ou paramagnétique de façon à pouvoir la déployer avec une première face en regard dudit espace à protéger ;
- déployer sur une deuxième face de ladite première feuille (15) ainsi façonnée de matériau électriquement conducteur de nature diamagnétique ou paramagnétique, opposée à ladite première face de ladite première feuille (15) de matériau électriquement conducteur, une ou plusieurs feuilles (14, 17) de matériau ferromagnétique comportant un alliage amorphe à base de fer et à structure nanocristalline non orientée et façonnées par cintrage.

10. Procédé de fabrication selon la revendication 9, **caractérisé en ce qu'**il comprend des étapes consistant à :
- façonner une deuxième feuille (16) de matériau électriquement conducteur de nature diamagnétique ou paramagnétique de façon à pouvoir la déployer avec une première face en regard de la source magnétique ;
- positionner ladite deuxième feuille (16) de matériau électriquement conducteur de sorte que la ou les feuilles (14, 17) de matériau ferromagnétique sont déployées sur une deuxième face de ladite deuxième feuille (16) de matériau électriquement conducteur, opposée à ladite première face de ladite deuxième feuille (16) de matériau électriquement conducteur.

11. Objet mobile comprenant au moins un organe électrique (13, 33) qui est une source de rayonnement magnétique, **caractérisé en ce qu'**il comprend un dispositif (21) selon l'une des revendications 1 à 8 de façon à assurer une protection de faible masse contre une énergie magnétique rayonnée par ladite source pour un espace à protéger à proximité de la source magnétique.

12. Objet mobile selon la revendication 11, **caractérisé en ce qu'**il est un véhicule automobile comprenant un habitacle qui comporte un espace (12) à proximité du dit organe, et **en ce que** ledit dispositif est disposé entre ledit organe et l'habitacle.

## Patentansprüche

1. Vorrichtung (1, 11, 21) zum Schutz eines Raumes (2, 12) in der Nähe einer Magnetquelle (3, 33) mit einer Form, die komplexer als eine einfache gerade Rohrform ist, vor einer von der Quelle ausgestrahlten magnetischen Energie, **dadurch gekennzeichnet, dass** sie umfasst:
- eine erste Platte (5, 15) aus elektrisch leitendem Material von diamagnetischer oder paramagnetischer Natur, welche durch Arbeitsgänge der Verformung oder des Gießens geformt wird, so dass sie zwischen der Quelle (3, 33) und dem zu schützenden Raum (2, 12) angeordnet werden kann,
- eine erste Platte (4, 14) aus ferromagnetischem Material, die durch Biegen geformt ist, so dass sie zwischen der Quelle (3, 33) und der ersten Platte (5, 15) aus elektrisch leitendem Material angeordnet werden kann, wobei das ferromagnetische Material eine amorphe Legierung auf der Basis von Eisen und mit einer nicht gerichteten nanokristallinen Struktur ist,
und dadurch, dass die erste Platte (5, 15) aus elektrisch leitendem Material von diamagnetischer oder paramagnetischer Natur und die erste Platte (4, 14) aus ferromagnetischem Material übereinanderliegend sind.

2. Vorrichtung (1, 11, 21) nach Anspruch 1, **dadurch gekennzeichnet, dass** sie umfasst:
- eine zweite Platte (6, 16) aus elektrisch leitendem Material von diamagnetischer oder paramagnetischer Natur, welche so geformt ist, dass sie zwischen der ersten Platte (4, 14) aus ferromagnetischem Material und der Magnetquelle (3, 33) angeordnet wird.

3. Vorrichtung (11, 21) nach einem der Ansprüche 1 oder 2, **dadurch gekennzeichnet, dass** sie umfasst:
- eine zweite Platte (7, 17) aus ferromagnetischem Material, welche zwischen der ersten Platte (4, 14) aus ferromagnetischem Material und der ersten Platte (5, 15) aus elektrisch leitendem Material angeordnet ist.

4. Vorrichtung (21) nach einem der vorhergehenden Ansprüche, **dadurch gekennzeichnet, dass** die Platte oder die Platten (15, 16) aus elektrisch leitendem Material eine Oberfläche aufweisen, die größer als diejenige der Platte oder der Platten (14, 17) aus ferromagnetischem Material ist, so dass sie die Platte oder die Platten aus ferromagnetischem Material vollständig bedecken.

5. Vorrichtung (1, 11, 21) nach einem der vorhergehenden Ansprüche, **dadurch gekennzeichnet, dass** das ferromagnetische Material eine relative magnetische Permeabilität (µᵣ) mit einem hohen Wert, der größer als 100.000 ist, aufweist.

6. Vorrichtung (1, 11, 21) nach einem der vorhergehenden Ansprüche, **dadurch gekennzeichnet, dass** die Legierung ein chemisches Element aus einer Gruppe umfasst, welche Silizium umfasst.

7. Vorrichtung (1, 11, 21) nach einem der vorhergehenden Ansprüche, **dadurch gekennzeichnet, dass** wenigstens eine Platte (4, 14, 7, 17) aus ferromagnetischem Material mit wenigstens einer Schicht aus elektrisch isolierendem Material bedeckt ist.

8. Vorrichtung nach einem der vorhergehenden Ansprüche, **dadurch gekennzeichnet, dass** das elektrisch leitende Material von diamagnetischer oder paramagnetischer Natur Aluminium umfasst.

9. Verfahren zur Herstellung einer Vorrichtung zum Schutz eines Raumes in der Nähe einer Magnetquelle vor einer von der Quelle ausgestrahlten magnetischen Energie, **dadurch gekennzeichnet, dass** es folgende Schritte umfasst:
- Formen, durch Arbeitsgänge der Verformung oder des Gießens, einer ersten Platte (15) aus elektrisch leitendem Material von diamagnetischer oder paramagnetischer Natur, um sie mit einer ersten Seite dem zu schützenden Raum zugewandt anordnen zu können;
- Anordnen, auf einer zweiten Seite der so geformten ersten Platte (15) aus elektrisch leitendem Material von diamagnetischer oder paramagnetischer Natur, die der ersten Seite der ersten Platte (15) aus elektrisch leitendem Material gegenüberliegt, einer oder mehrerer Platten (14, 17) aus ferromagnetischem Material, die eine amorphe Legierung auf der Basis von Eisen und mit einer nicht gerichteten nanokristallinen Struktur aufweisen und durch Biegen geformt sind.

10. Verfahren zur Herstellung nach Anspruch 9, **dadurch gekennzeichnet, dass** es folgende Schritte umfasst:
- Formen einer zweiten Platte (16) aus elektrisch leitendem Material von diamagnetischer oder paramagnetischer Natur, um sie mit einer ersten Seite der Magnetquelle zugewandt anordnen zu können;
- Positionieren der zweiten Platte (16) aus elektrisch leitendem Material derart, dass die Platte oder die Platten (14, 17) aus ferromagnetischem Material auf einer zweiten Seite der zweiten Platte (16) aus elektrisch leitendem Material angeordnet sind, die der ersten Seite der zweiten Platte (16) aus elektrisch leitendem Material gegenüberliegt.

11. Bewegliches Objekt, welches wenigstens ein elektrisches Organ (13, 33) umfasst, welches eine Quelle von magnetischer Strahlung ist, **dadurch gekennzeichnet, dass** es eine Vorrichtung (21) nach einem der Ansprüche 1 bis 8 umfasst, um so einen Schutz von geringer Masse vor einer von der Quelle ausgestrahlten magnetischen Energie für einen zu schützenden Raum in der Nähe der Magnetquelle sicherzustellen.

12. Bewegliches Objekt nach Anspruch 11, **dadurch gekennzeichnet, dass** es ein Kraftfahrzeug ist, das einen Innenraum umfasst, welcher einen Raum (12) in der Nähe des Organs aufweist, und dadurch, dass die Vorrichtung zwischen dem Organ und dem Innenraum angeordnet ist.

## Claims

1. Device (1, 11, 21) for protecting a space (2, 12) adjacent to a magnetic source (3, 33) having a more complex shape than simple straight tabular shape, against magnetic energy radiated by said source, **characterized in that** it comprises:
- a first sheet (5, 15) of diamagnetic or paramagnetic electrically conductive material, which sheet is shaped by actions of deforming or of moulding so that it can be spread between said source (3, 33) and said space to be protected (2, 12),
- a first sheet (4, 14) of ferromagnetic material, which sheet is shaped by flection so that it can be spread between said source (3, 33) and said first sheet (5, 15) of electrically conductive material, the ferromagnetic material being an iron-based amorphous alloy having a non-orientated nanocrystalline structure,
and **in that** the first sheet (5, 15) of diamagnetic or paramagnetic electrically conductive material and the first sheet (4, 14) of ferromagnetic material are stacked.

2. Device (1, 11, 21) according to Claim 1, **characterized in that** it comprises:
- a second sheet (6, 16) of diamagnetic or paramagnetic electrically conductive material, which sheet is shaped so as to be spread between said first sheet (4, 14) of ferromagnetic material and said magnetic source (3, 33).

3. Device (11, 21) according to either Claim 1 or 2, **characterized in that** it comprises:
- a second sheet (7, 17) of ferromagnetic material, which sheet is spread between said first sheet (4, 14) of ferromagnetic material and said first sheet (5, 15) of electrically conductive material.

4. Device (21) according to one of the preceding claims, **characterized in that** said sheet(s) (15, 16) of electrically conductive material has(have) a surface area which is greater than that of the sheet (s) (14, 17) of ferromagnetic material such as to completely cover said sheet(s) of ferromagnetic material.

5. Device (1, 11, 21) according to one of the preceding claims, **characterized in that** the ferromagnetic material has a relative magnetic permeability (µᵣ) with a high value greater than 100 000.

6. Device (1, 11, 21) according to one of the preceding claims, **characterized in that** said alloy comprises a chemical element of a group comprising silicon.

7. Device (1, 11, 21) according to one of the preceding claims, **characterized in that** at least one sheet (4, 14, 7, 17) of ferromagnetic material is covered with at least one layer of electrically insulating material.

8. Device according to one of the preceding claims, **characterized in that** the diamagnetic or paramagnetic electrically conductive material comprises aluminum.

9. Method of manufacturing a device for protecting a space adjacent to a magnetic source against magnetic energy radiated by said source, **characterized in that** it comprises steps of:
- shaping by action of deforming or of moulding a first sheet (15) of diamagnetic or paramagnetic electrically conductive material in order to be able to spread the sheet with a first face opposite said space to be protected;
- spreading, over a second face of said first sheet (15) thus shaped of diamagnetic or paramagnetic electrically conductive material, which is opposite said first face of said first sheet (15) of electrically conductive material, one or more sheets (14, 17) of ferromagnetic material including an iron-based amorphous alloy having a non-oriented nanocrystalline structure and being shaped by flection.

10. Manufacturing method according to Claim 9, **characterized in that** it comprises steps of:
- shaping a second sheet (16) of diamagnetic or paramagnetic electrically conductive material in order to be able to spread it with a first face opposite the magnetic source;
- positioning said second sheet (16) of electrically conductive material such that the sheet (s) (14, 17) of ferromagnetic material is(are) spread over a second face of said second sheet (16) of electrically conductive material, which is opposite said first face of said second sheet (16) of electrically conductive material.

11. Mobile object comprising at least one electric member (13, 33) which is a source of magnetic radiation, **characterized in that** it comprises a device (21) according to one of Claims 1 to 8 such as to provide a low-mass protection against magnetic energy radiated by said source for a space to be protected adjacent to the magnetic source.

12. Mobile object according to Claim 11, **characterized in that** it is a motor vehicle comprising a compartment which includes a space (12) adjacent to said member, and **in that** said device is placed between said member and the compartment.
